(19) 

Europäisches
Patentamt
European
Patent Office
Office européen
des brevets

(11) **EP 4 385 803 A1**

(12) **EUROPEAN PATENT APPLICATION**
published in accordance with Art. 153(4) EPC

(43) Date of publication:
**19.06.2024 Bulletin 2024/25**

(21) Application number: **23861670.0**

(22) Date of filing: **05.09.2023**

(51) International Patent Classification (IPC):
***B60L 53/126*** *(2019.01)*     ***B60L 53/80*** *(2019.01)*
***B60L 53/53*** *(2019.01)*     ***G06Q 10/083*** *(2024.01)*

(52) Cooperative Patent Classification (CPC):
**B60L 53/126; B60L 53/53; B60L 53/80**

(86) International application number:
**PCT/KR2023/013276**

(87) International publication number:
**WO 2024/054008 (14.03.2024 Gazette 2024/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **05.09.2022   KR 20220111915
04.09.2023   KR 20230117288**

(71) Applicant: **LG Energy Solution, Ltd.
Seoul 07335 (KR)**

(72) Inventors:
• **KIM, Ji-Eun
  Daejeon 34122 (KR)**
• **LEE, Sung-Gun
  Daejeon 34122 (KR)**
• **LEE, Keun-Wook
  Daejeon 34122 (KR)**

(74) Representative: **Plasseraud IP
66, rue de la Chaussée d'Antin
75440 Paris Cedex 09 (FR)**

(54) **APPARATUS AND METHOD FOR PAIRING BATTERIES**

(57)    A battery pairing apparatus according to an embodiment of the present disclosure includes a communication unit configured to receive battery information for a plurality of batteries; an index value determining unit configured to determine an index value for a plurality of performance indexes preset for each of the plurality of batteries, based on the battery information; and a battery determining unit configured to compare the plurality of index values determined for the plurality of batteries and pair corresponding batteries among the plurality of batteries according to the comparison result.

FIG. 1

BATTERY PAIRING APPARATUS — 100
COMMUNICATION UNIT — 110
INDEX VALUE DETERMINING UNIT — 120
BATTERY DETERMINING UNIT — 130
STORAGE UNIT — 140

EP 4 385 803 A1

## Description

### TECHNICAL FIELD

The present application claims priority to Korean Patent Application No. 10-2022-0111915 filed on September 5, 2022 in the Republic of Korea and Korean Patent Application No. 10-2023-0117288 filed on September 4, 2023 in the Republic of Korea, the disclosures of which are incorporated herein by reference.

The present disclosure relates to a battery pairing apparatus and method, and more particularly, to a battery pairing apparatus and method for pairing corresponding batteries among a plurality of batteries applied to a battery swapping station (BSS).

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As electric vehicles or the like are commercialized, the demand for high-capacity and high-performance batteries is increasing. However, as the capacity of the battery increases, the disadvantage that the time required to charge the battery also increases is highlighted. To solve this problem, technology for rapidly charging batteries is being developed, but there are concerns that rapid charging may accelerate battery deterioration.

To solve this problem, a battery swapping station (BSS) has recently been introduced. By replacing the battery used in an electric vehicle or the like, with a spare battery provided at the battery swapping station, the user has an advantage of quickly using a battery that has been charged to a certain level or above (e.g., a fully charged battery).

Meanwhile, depending on devices, a plurality of spare batteries may be required. If the states of the plurality of selected spare batteries (e.g., SOC (State of charge), SOH (State of health), etc.) are different, there is a problem that the output and capacity that can be obtained through the spare batteries are limited. Therefore, a method is required to provide batteries of similar states by pairing the batteries to achieve the best efficiency.

### DISCLOSURE

#### Technical Problem

The present disclosure is designed to solve the problems of the related art, and therefore the present disclosure is directed to providing a battery pairing apparatus and method capable of managing usage efficiency and management efficiency for batteries by pairing and providing corresponding batteries.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

#### Technical Solution

A battery pairing apparatus according to one aspect of the present disclosure may comprise: a communication unit configured to receive battery information for a plurality of batteries; an index value determining unit configured to determine an index value for a plurality of performance indexes preset for each of the plurality of batteries, based on the battery information; and a battery determining unit configured to compare the plurality of index values determined for the plurality of batteries and pair corresponding batteries among the plurality of batteries according to the comparison result.

The battery determining unit may be configured to compare the index values of the plurality of batteries according to priorities preset in the plurality of performance indexes and pair corresponding batteries among the plurality of batteries.

The battery determining unit may be configured to preferentially compare the plurality of index values for a performance index with a high priority.

The battery determining unit may be configured to calculate a SOH difference of the paired batteries and release pairing for the paired batteries when the calculated SOH difference is greater than or equal to a preset threshold value.

The battery determining unit may be configured to determine the plurality of non-pair batteries whose pairing is released among the plurality of batteries, compare the plurality of index values with respect to the plurality of non-pair batteries, and pair corresponding batteries among the non-pair batteries according to the comparison result.

The plurality of performance indexes may be configured to include at least one of SOC, SOH, unit charge capacity and deterioration rate.

The index value determining unit may be configured to calculate a cumulative SOC and a cumulative charge capacity of each of the plurality of batteries from the battery information and calculate the unit charge capacity according to the cumulative SOC and the cumulative charge capacity.

The index value determining unit may be configured to calculate a charge capacity per SOC for each preset unit period and calculate the unit charge capacity by calculating an average value of the charge capacity per SOC for a preset criterion period.

The index value determining unit may be configured to calculate a SOH change amount and a cumulative usage amount for each of the plurality of batteries from the battery information and calculate the deterioration rate of each of the plurality of batteries based on the SOH change amount and the cumulative usage amount.

A battery swapping station according to another aspect of the present disclosure may comprise the battery pairing apparatus according to an aspect of the present disclosure.

A server according to still another aspect of the present disclosure may comprise the battery pairing apparatus according to an aspect of the present disclosure.

A battery pairing method according to still another aspect of the present disclosure may comprise: a battery information receiving step of receiving battery information for a plurality of batteries; an index value determining step of determining an index value for a plurality of performance indexes for the plurality of batteries, based on the battery information; an index value comparing step of comparing the plurality of index values determined for the plurality of batteries; and a pairing step of pairing corresponding batteries among the plurality of batteries according to the comparison result.

Advantageous Effects

According to one aspect of the present disclosure, the battery pairing apparatus has an advantage of pairing batteries with the most similar battery performance and battery efficiency by comparing a plurality of batteries according to various performance indexes.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing a battery pairing apparatus according to an embodiment of the present disclosure.
FIG. 2 is a diagram schematically showing a plurality of performance indexes according to an embodiment of the present disclosure.
FIG. 3 is a diagram schematically showing a battery information table according to an embodiment of the present disclosure.
FIG. 4 is a diagram schematically showing a pairing information table according to an embodiment of the present disclosure.
FIGS. 5 to 9 are diagrams schematically showing embodiments in which a plurality of batteries are paired according to the present disclosure.
FIG. 10 is a diagram schematically showing a server according to another embodiment of the present disclosure.
FIG. 11 is a diagram schematically showing a battery pairing method according to still another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

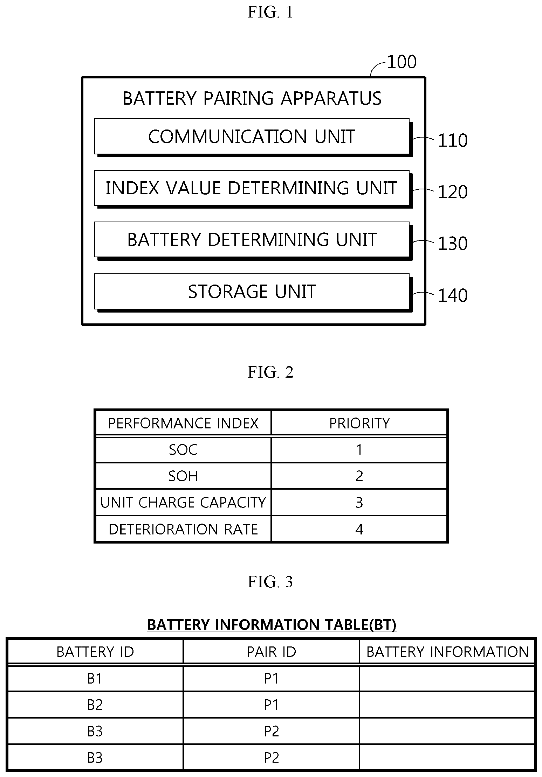

FIG. 1 is a diagram schematically showing a battery pairing apparatus 100 according to an embodiment of the present disclosure.

Referring to FIG. 1, the battery pairing apparatus 100 may include a communication unit 110, an index value determining unit 120, and a battery determining unit 130.

The communication unit 110 may be configured to receive battery information for a plurality of batteries.

Here, the battery means one physically separable independent cell including a negative electrode terminal and a positive electrode terminal. For example, one lithiumion battery or lithium polymer battery may be regarded as a battery. Additionally, the battery may mean a battery bank, a battery module or a battery pack in which a plurality of cells are connected in series and/or parallel.

Specifically, the communication unit 110 may receive battery information about a plurality of batteries from the outside. For example, the communication unit 110 may receive state information for at least one of voltage, current, capacity, resistance, temperature, SOC (state of charge), and SOH (state of health) for the plurality of batteries and usage information about usage pattern as the battery information.

The index value determining unit 120 may be configured to determine index values for a plurality of performance indexes preset for each of the plurality of batteries, based on the battery information.

Specifically, the index value determining unit 120 may determine the index values for the plurality of performance indexes for each of the plurality of batteries using the battery information received by the communication unit 110.

For example, the plurality of performance indexes may be configured to include at least one of SOC (State of charge), SOH (State of health), unit charge capacity, and deterioration rate. Here, the unit charge capacity is an index of the charge capacity required to increase the SOC of the battery by a preset criterion SOC. The deterioration rate is an index of the degree of deterioration of the battery for each unit usage amount.

Below, the plurality of performance indexes will be described according to the embodiment of FIG. 2, but note that the performance indexes that can be compared for pairing a plurality of batteries are not limited by the embodiment of FIG. 2.

FIG. 2 is a diagram schematically showing a plurality of performance indexes according to an embodiment of the present disclosure. For example, in the embodiment of FIG. 2, the plurality of performance indexes may include SOC, SOH, unit charge capacity, and deterioration rate.

The battery determining unit 130 may be configured to compare the plurality of index values determined for the plurality of batteries.

Specifically, the battery determining unit 130 may compare the index values of the plurality of batteries for each performance index. More specifically, the battery determining unit 130 may distinguish similar index values among the plurality of index values for each of the plurality of performance indexes.

For example, assuming that the battery determining unit 130 pairs two batteries, the battery determining unit 130 may distinguish two index values with the smallest difference among the plurality of index values. In the embodiment of FIG. 2, the battery determining unit 130 may check the SOC of the plurality of batteries and distinguish two most adjacent SOCs among the plurality of SOCs. In addition, the battery determining unit 130 may check the SOH of the plurality of batteries and distinguish two most adjacent SOHs among the plurality of SOHs. In addition, the battery determining unit 130 may check the unit charge capacity of the plurality of batteries and distinguish two most adjacent unit charge capacities among the plurality of unit charge capacities. Lastly, the battery determining unit 130 may check the deterioration rate of the plurality of batteries and distinguish two most adjacent deterioration rates among the plurality of deterioration rates.

The battery determining unit 130 may be configured to pair corresponding batteries among the plurality of batteries according to the comparison result.

Specifically, the battery determining unit 130 may pair the most similar batteries among the plurality of batteries, considering the index value comparison result. For example, the battery determining unit 130 may pair corresponding batteries among the plurality of batteries depending on whether the index values for the plurality of performance indexes are similar. Therefore, among the plurality of batteries, batteries with the most similar index values on the whole for the plurality of performance indexes may be paired.

For example, in the embodiment of FIG. 2, among the plurality of batteries, batteries with the most similar SOC, SOH, unit charge capacity, and deterioration rate on the whole may be paired. In other words, the paired batteries may be batteries with the most similar battery performance and battery efficiency among the plurality of batteries.

In other words, the battery pairing apparatus 100 according to an embodiment of the present disclosure has an advantage of pairing batteries with the most similar battery performance and battery efficiency by comparing a plurality of batteries according to various performance indices.

The battery pairing apparatus 100 may further include a storage unit 140. The storage unit 140 may store data necessary for operation and function of each component of the battery pairing apparatus 100, data generated in the process of performing the operation or function, or the like. The storage unit 140 is not particularly limited in its type as long as it is a known information storage means that can record, erase, update and read data. As an example, the information storage means may include RAM, flash memory, ROM, EEPROM, registers, and the like. In addition, the storage unit 140 may store program codes in which processes executable by the control unit are defined.

For example, the storage unit 140 may store the battery information about the plurality of batteries. Additionally, the storage unit 140 may store the plurality of index values determined by the index value determining unit 120 for each performance index.

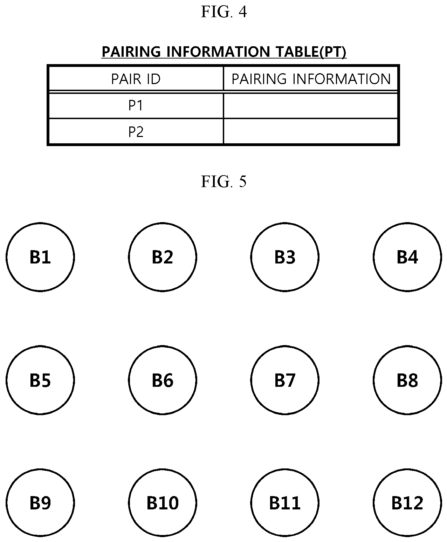

FIG. 3 is a diagram schematically showing a battery information table BT according to an embodiment of the present disclosure. FIG. 4 is a diagram schematically showing a pairing information table PT according to an embodiment of the present disclosure.

The battery determining unit 130 may generate (or record) a battery information table BT and a pairing information table PT after pairing corresponding batteries among the plurality of batteries.

Specifically, the battery information table BT is a table in which information about each of the plurality of batteries is recorded. The battery information table BT may include a battery ID, a pair ID, and state information. In other words, the primary key of the battery information table BT is the battery ID. Also, the pair ID is information that may specify the paired batteries, and the paired batteries may have the same pair ID. The battery information may include individual information about each battery. For example, the battery determining unit 130 may record the battery information received by the communication unit 110 in the battery information table BT.

For example, in the embodiment of FIG. 3, the battery ID of the first battery is B1, and the pair ID is P1. The battery ID of the second battery is B2, and the pair ID is P2. In other words, the first battery and the second battery are batteries paired with each other. The battery ID of the third battery is B3, and the pair ID is P3. The battery ID of the fourth battery is B4, and the pair ID is P4. In other words, the third battery and the fourth battery are batteries paired with each other.

The pairing information table PT is a table in which the plurality of pairing information is recorded. The pairing information table PT may include a pair ID and pairing information. In other words, the primary key of the pairing information table PT is the pair ID. The pairing information may include common information about the paired batteries. Preferably, the pairing information may include common information after the paired batteries are paired with the corresponding pair ID. For example, the pairing information may include information about the battery swapping station containing the paired batteries, charging C-rate information, charging time information, usage time information, used vehicle information, driving distance information, GPS location information, battery replacement number information, and the like. For example, the battery determining unit 130 may check the usage history of the paired batteries and record the pairing information in the pairing information table PT.

For example, in the embodiment of FIG. 4, the pair ID of the first pair is P 1, and the pair ID of the second pair is P2. Referring to FIGS. 3 and 4, since the pair ID in the battery information table BT is a foreign key, the pair ID, the battery information, and the pairing information for each battery may be checked through the battery information table BT and the pairing information table PT.

Here, because the pairing information is common to the paired batteries, if the pairing information is recorded for each battery, the pairing information may be recorded in duplicate as much as the number of paired batteries. In other words, system resources may be used inefficiently due to duplicate recording of the same information. Therefore, the battery pairing apparatus 100 according to an embodiment of the present disclosure manages the pairing information common to the paired batteries in a separate table, thereby having an advantage of improving management efficiency for the plurality of batteries and efficiently saving system resources required for information storage.

The battery determining unit 130 may be configured to compare the index values of the plurality of batteries according to the priorities set in the plurality of performance indexes and pair corresponding batteries among the plurality of batteries according to the comparison result.

Specifically, the priority may be set in advance for the plurality of performance indexes. Here, the priority may be set according to the order of the performance indexes that are considered for pairing batteries with substantially the same performance efficiency. In other words, the priority of the performance index, which is considered first when comparing the performance efficiency of batteries, may be set high.

In the embodiment of FIG. 2, the priority may be set high in the order of SOC, SOH, unit charge capacity, and deterioration rate. That is, in the embodiment of FIG. 2, when comparing the performance efficiency of the plurality of batteries, SOC is the most important index, SOH is the next important index, and the deterioration rate is the last index considered.

For example, batteries with a SOC difference of 1% or less may be considered first as pairing targets. Additionally, batteries with an SOH difference of 1% or less may be considered for pairing targets. Next, batteries with a unit charge capacity difference of 10% or less may be considered for pairing targets. Lastly, batteries with a deterioration rate difference of 10% or less may be considered for pairing targets.

Preferably, the battery determining unit 130 may be configured to preferentially compare the plurality of index values with respect to the performance index with a high priority. In other words, the index value comparison result for the performance index with a high priority may have more influence on battery pairing than the index value comparison result for a performance index with a low priority.

For example, in the embodiment of FIG. 2, the battery determining unit 130 may consider the SOC comparison result, the SOH comparison result, the unit charge capacity comparison result, and the deterioration rate comparison result of the plurality of batteries in order and pair the corresponding batteries. For example, if the priority for each performance index according to the embodiment of FIG. 2 is considered, batteries not having similar deterioration rates but having similar SOCs and SOHs may be paired among the plurality of batteries.

In the above, the priority set for the plurality of performance indexes according to the embodiment of FIG. 2 has been described, but note that the plurality of performance indexes and the priority for each performance index are not limited by the embodiment of FIG. 2.

An embodiment in which the plurality of batteries are paired according to the priorities preset in the plurality of performance indexes will be described with reference to FIGS. 5 to 9. FIGS. 5 to 9 are diagrams schematically showing embodiments in which a plurality of batteries are paired according to the present disclosure.

FIG. 5 shows a plurality of batteries. Referring to FIG. 5, the first to twelfth batteries B 1 to B12 may be provided. First, the battery determining unit 130 may compare the index value of the first performance index with the highest priority for the first to twelfth batteries B 1 to B 12.

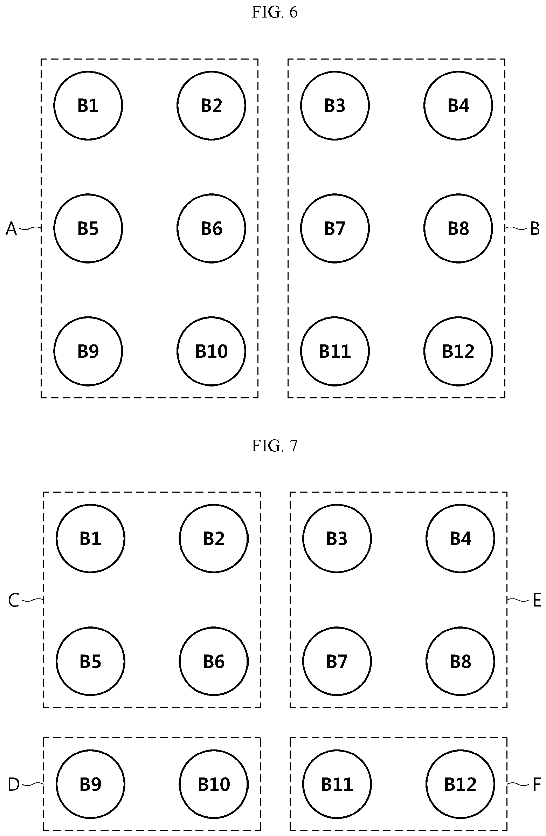

FIG. 6 is a diagram showing the result of comparing the index values of the first performance indexes of the plurality of batteries by the battery determining unit 130. Referring to FIG. 6, the battery determining unit 130 may classify the first to twelfth batteries B 1 to B 12 into A group and B group according to the result of comparing the index values of the first performance indexes. The A group includes the first battery B 1, the second battery B2, the fifth battery B5, the sixth battery B6, the ninth battery B9 and the tenth battery B 10, and the B group includes the third battery B3, the fourth battery B4, the seventh battery B7, the eighth battery B8, the eleventh battery B 1 1 and the twentieth battery B 12.

FIG. 7 is a diagram showing the result of comparing the index values of the first and second performance indexes of the plurality of batteries by the battery determining unit 130. Referring to FIG. 7, the battery determining unit 130 may classify the first to twelfth batteries B 1 to B 12 into C group, D group, E group, and F group according to the result of comparing the index values of the first and second performance indexes. The C group includes the first battery B 1, the second battery B2, the fifth battery B5, and the sixth battery B6, and the D group includes the ninth battery B9 and the tenth battery B 10. The E group includes the third battery B3, the fourth battery B4, the seventh battery B7, and the eighth battery B8, and the F group includes the eleventh battery B 1 1 and the twelfth battery B 12.

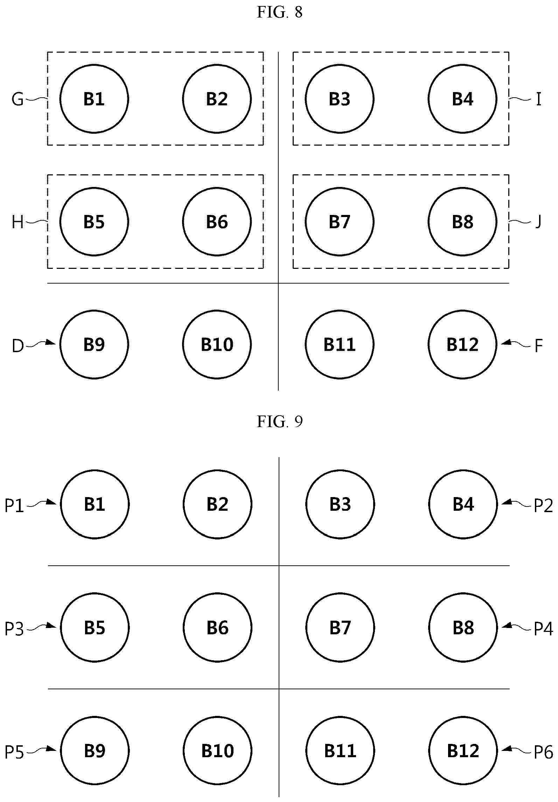

FIG. 8 is a diagram showing the result of comparing the index values of the first to third performance indexes of the plurality of batteries by the battery determining unit 130. Referring to FIG. 8, the battery determining unit 130 may classify the first to twelfth batteries B 1 to B 12 into D group, F group, G group, H group, I group, and J group according to the result of comparing the index values of the first to third performance indexes. D group and F group are as shown in FIG. 7. The G group includes the first battery B 1 and the second battery B2, and the H group includes the fifth battery B5 and the sixth battery B6. The I group includes the third battery B3 and the fourth battery B4, and the J group includes the seventh battery B7 and the eighth battery B8.

FIG. 9 is a diagram showing the result of pairing the plurality of batteries by the battery determining unit 130. Referring to FIG. 9, the first battery B1 and the second battery B2 are paired, and the pair ID is P1. The third battery B3 and the fourth battery B4 are paired, and the pair ID is P2. The fifth battery B5 and the sixth battery B6 are paired, and the pair ID is P3. The seventh battery B7 and the eighth battery B8 are paired, and the pair ID is P4. The ninth battery B9 and the tenth battery B 10 are paired, and the pair ID is P5. The eleventh battery B11 and the twelfth battery B12 are paired, and the pair ID is P6.

Below, an embodiment in which the index value determining unit 120 calculates unit charge capacity will be described.

The index value determining unit 120 may be configured to calculate the cumulative SOC and the cumulative charge capacity of each of the plurality of batteries from the battery information. Specifically, the index value determining unit 120 may calculate the cumulative SOC and the cumulative charge capacity of the battery based on the state information and/or the usage information included in the battery information. Here, the cumulative SOC means the total SOC [%] that the battery has been charged so far. Also, the cumulative charge capacity refers to the total amount of charge capacity [Ah] that the battery has been charged so far.

In one embodiment, the index value determining unit 120 may be configured to calculate the unit charge capacity of each of the plurality of batteries according to the cumulative SOC and the cumulative charge capacity. In other words, the index value determining unit 120 may calculate the unit charge capacity for the entire usage period of the battery.

Specifically, the unit charge capacity is an index of the charge capacity required to increase the SOC of the battery by a preset criterion SOC. Preferably, the criterion SOC may be preset to SOC 1%. In other words, the unit charge capacity may refer to the charge capacity required to increase the SOC of the battery by 1%. For example, the index value determining unit 120 may calculate the unit charge capacity according to the ratio of the cumulative charge capacity to the cumulative SOC. The index value determining unit 120 may calculate the unit charge capacity by calculating the formula "cumulative charge capacity ÷ cumulative SOC".

In another embodiment, the index value determining unit 120 may calculate the unit charge capacity of each of the plurality of batteries according to the cumulative SOC and the cumulative charge capacity for each unit period.

More specifically, the index value determining unit 120 may be configured to calculate the charge capacity per SOC for each preset unit period and calculate the unit charge capacity by calculating the average value of the charge capacity per SOC for the preset criterion period. For example, the index value determining unit 120 may calculate the unit charge capacity using Equation 1 below.

[Equation 1]

$$uCh = \frac{1}{n} \times \sum_{i=1}^{n} \frac{Ch\_i}{SOC\_i}$$

Here, uCh is the unit charge capacity, and Ch_i is the cumulative charge capacity for the unit period. SOC_i is the cumulative SOC for the unit period, and n is the criterion period.

For example, assume that the criterion period is 30 days. The index value determining unit 120 may calculate the charge capacity per SOC for every day. In addition, the index value determining unit 120 may calculate the unit charge capacity by calculating the average value of the charge capacity per SOC for 30 days.

Below, an embodiment in which the index value determining unit 120 calculates the deterioration rate will be described.

The index value determining unit 120 may be configured to calculate the SOH change amount and the cumulative usage amount of each of the plurality of batteries from the battery information.

Here, the SOH change amount is the difference between the initial SOH and the current SOH, and the cumulative usage amount refers to the total usage amount that the battery has been used until now. For example, the cumulative discharge amount (Ah) until now, the cumulative energy (kWH), or the cumulative driving distance (Km) may be applied to the cumulative usage amount.

The index value determining unit 120 may be configured to calculate the deterioration rate of each of the plurality of batteries based on the SOH change amount and on cumulative usage amount.

Here, the deterioration rate may mean the degree of deterioration of the battery for each unit usage amount. Specifically, the index value determining unit 120 may calculate the deterioration rate for each of the plurality of batteries by calculating the ratio of the SOH change amount to the cumulative usage amount. For example, the index value determining unit 120 may calculate the deterioration rate using Equation 2 below.

[Equation 2]

$$uSOH = \frac{\Delta SOH}{U}$$

Here, uSOH is the deterioration rate, $\Delta$SOH is the SOH change amount, and U is the cumulative usage amount.

For example, assume that the initial SOH of the battery is SOHi and the current SOH is SOHc. The index value determining unit 120 may calculate the deterioration rate by calculating the formula "(SOHi - SOHc) ÷ U".

The battery determining unit 130 may be configured to calculate the SOH difference of the paired batteries. Additionally, the battery determining unit 130 may be configured to release pairing for the paired batteries when the calculated SOH difference is greater than or equal to a preset threshold value.

Specifically, since the paired batteries are used and charged together after pairing, in theory, the states of the paired batteries should be substantially the same. However, due to a defect in one of the paired batteries or a defect in the load, the SOH of the paired batteries may differ by the threshold value or more in the actual usage environment. If the SOH differs by the threshold value or more, the deterioration between the paired batteries is quite significant, so even if they are used together, the performance efficiency is bound to be poor. Therefore, the battery determining unit 130 may release pairing between the batteries whose SOH difference is greater than or equal to the threshold value.

The battery determining unit 130 may be configured to determine a plurality of non-pair batteries that are unpaired among the plurality of batteries, compare the plurality of index values for the plurality of non-pair batteries, and pair corresponding batteries according to the comparison result.

Specifically, the battery determining unit 130 may pair the non-pair batteries again by comparing the index values for the plurality of performance indexes. In other words, even if a battery is unpaired, there is a possibility that it can be paired with another battery, considering its current state. Therefore, the battery determining unit 130 may re-pair corresponding non-pair batteries by comparing the index values of the plurality of performance indexes for reuse of the non-pair batteries.

In other words, the battery pairing apparatus 100 according to an embodiment of the present disclosure has an advantage of improving usage efficiency of the battery by repairing the non-pair batteries whose pairing has been released.

The battery pairing apparatus 100 according to an embodiment of the present disclosure may be included in a battery swapping station. The battery swapping station may include a measuring unit that measures the state of the installed battery. For example, the measuring unit may measure current, voltage, temperature, and resistance of the battery, and estimate SOC and SOH of the battery based on the measurement results. The communication unit 110 may receive battery information about the plurality of batteries from the measuring unit. The index value determining unit 120 may determine the index values of the plurality of performance indexes for the plurality of batteries. The battery determining unit 130 may pair corresponding batteries among the plurality of batteries included in the battery swapping station, based on the index value comparison result. The battery pairing apparatus 100 is included in the battery swapping station and has an advantage of quickly pairing a plurality of batteries included in the battery swapping station.

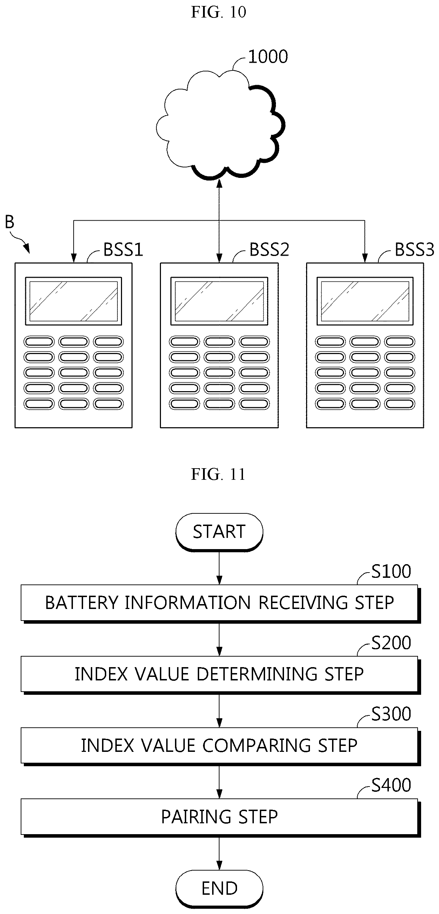

FIG. 10 is a diagram schematically showing a server according to another embodiment of the present disclosure.

Referring to FIG. 10, the server 1000 may include the battery pairing apparatus. Additionally, the server 1000 may be connected to communicate with at least one battery swapping station. For example, in the embodiment of FIG. 10, the server 1000 may be connected to communicate with the first to third battery swapping stations BSS1, BSS2, and BSS3.

Each battery swapping station includes an input unit, a display unit, and a battery unit, and the battery unit may be equipped with a battery. Preferably, the battery included in the battery unit may be charged up to a preset charging end voltage. Also, a battery having SOC higher than the criterion SOC may become a candidate battery that can be determined as a target battery. The battery swapping station may periodically transmit the battery information about the battery provided in the battery unit to the server 1000.

The server 1000 may periodically receive the battery information about the plurality of batteries from the plurality of battery swapping stations. Also, when a battery replacement request is input by the user, the server 1000 may determine an optimal battery among the plurality of batteries as the target battery and provide information about the target battery to the user.

In one embodiment, the server 1000 may pair corresponding batteries among the plurality of batteries provided at each battery swapping station. In other words, the server 1000 may enable a user to immediately obtain the paired batteries by pairing batteries located in the same physical space. When the server 1000 receives a battery replacement request from a user, the server 1000 may provide the battery information and the pairing information about the paired batteries to the user. The user may check the battery information and the pairing information and secure the paired batteries from the battery swapping station.

In another embodiment, the server 1000 may pair corresponding batteries among the plurality of batteries provided in a plurality of battery swapping stations. Preferably, server 1000 may pair corresponding batteries among the plurality of batteries provided in adjacent battery swapping stations.

For example, when the paired batteries are provided in the same battery swapping station, the server 1000 may transmit the battery information and the pairing information to the user in response to the battery replacement request. The user may check the battery information and the pairing information and secure the paired batteries from the battery swapping station.

As another example, when the paired batteries are provided in another battery swapping station, the server 1000 may provide the battery information and the pairing information to the user or manager. Based on the battery information and the pairing information, the manager may move one of the paired batteries to a battery swapping station equipped with the other. Based on manager battery information and manager pairing information, the user may secure a battery corresponding to the pairing information provided by each battery swapping station.

FIG. 11 is a diagram schematically showing a battery pairing method according to still another embodiment of the present disclosure.

Referring to FIG. 11, the battery pairing method may include a battery information receiving step (S100), an index value determining step (S200), an index value comparing step (S300), a pairing step (S400) and a battery information providing step.

Preferably, each step of the battery pairing method may be performed by the battery pairing apparatus 100. Hereinafter, for convenience of explanation, contents overlapping with the previously described contents will be omitted or briefly described.

The battery information receiving step (S100) is a step of receiving battery information about a plurality of batteries, and may be performed by the communication unit 110.

For example, the communication unit 110 may be connected to communicate with at least one battery swapping station. Additionally, the communication unit 110 may receive battery information about the battery provided in the battery swapping station from the battery swapping station.

The index value determining step (S200) is a step of determining index values for a plurality of performance indexes for the plurality of batteries, based on the battery information, and may be performed by the index value determining unit 120.

For example, in the embodiment of FIG. 2, the index value determining unit 120 may determine an index value for SOC, SOH, unit charge capacity, and deterioration rate based on the battery information.

The index value comparing step (S300) is a step of comparing the plurality of index values determined with respect to the plurality of batteries, and may be performed by the battery determining unit 130.

For example, the battery determining unit 130 may compare the index values of the plurality of batteries by considering the priorities preset in the plurality of performance indexes. In the embodiment of FIG. 2, the priorities may be set in advance in the order of SOC, SOH, unit charge capacity, and deterioration rate. The index value determining unit 120 may compare the SOC, SOH, unit charge capacity, and deterioration rate of the plurality of batteries in that order.

The pairing step (S400) is a step of pairing corresponding batteries among the plurality of batteries according to the comparison result, and may be performed by the battery determining unit 130.

For example, in the embodiment of FIG. 2, the battery determining unit 130 may pair corresponding batteries among the plurality of batteries according to the result of sequentially comparing SOC, SOH, unit charge capacity, and deterioration rate. In other words, the index value comparison result of a performance index with a high priority may have more influence on battery pairing than the index value comparison result of a performance index with a low priority.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

    100: battery pairing apparatus
    110: communication unit
    120: index value determining unit
    130: battery determining unit
    140: storage unit
    1000: server

**Claims**

1. A battery pairing apparatus, comprising:

    a communication unit configured to receive battery information for a plurality of batteries;
    an index value determining unit configured to determine an index value for a plurality of performance indexes preset for each of the plurality of batteries, based on the battery information; and
    a battery determining unit configured to compare the plurality of index values determined for the plurality of batteries and pair corresponding batteries among the plurality of batteries according to the comparison result.

2. The battery pairing apparatus according to claim 1, wherein the battery determining unit is configured to compare the index values of the plurality of batteries according to priorities preset in the plurality of performance indexes and pair corresponding batteries among the plurality of batteries.

3. The battery pairing apparatus according to claim 2, wherein the battery determining unit is configured to preferentially compare the plurality of index values for a performance index with a high priority.

4. The battery pairing apparatus according to claim 1, wherein the battery determining unit is configured to calculate a SOH difference of the paired batteries and release pairing for the paired batteries when the calculated SOH difference is greater than or equal to a preset threshold value.

5. The battery pairing apparatus according to claim 4, wherein the battery determining unit is configured to determine the plurality of non-pair batteries whose pairing is released among the plurality of batteries, compare the plurality of index values with respect to the plurality of non-pair batteries, and pair corresponding batteries among the non-pair batteries according to the comparison result.

6. The battery pairing apparatus according to claim 1, wherein the plurality of performance indexes are configured to include at least one of SOC, SOH, unit charge capacity and deterioration rate.

7. The battery pairing apparatus according to claim 6, wherein the index value determining unit is configured to calculate a cumulative SOC and a cumulative charge capacity of each of the plurality of batteries from the battery information and calculate the unit charge capacity according to the cumulative SOC and the cumulative charge capacity.

8. The battery pairing apparatus according to claim 7, wherein the index value determining unit is configured to calculate a charge capacity per SOC for each preset unit period and calculate the unit charge capacity by calculating an average value of the charge capacity per SOC for a preset criterion period.

9. The battery pairing apparatus according to claim 6, wherein the index value determining unit is configured to calculate a SOH change amount and a cumulative usage amount for each of the plurality of batteries from the battery information and calculate the deterioration rate of each of the plurality of batteries based on the SOH change amount and the cumulative usage amount.

10. A battery swapping station, comprising the battery pairing apparatus according to any one of claims 1 to 9.

11. A server, comprising the battery pairing apparatus according to any one of claims 1 to 9.

12. A battery pairing method, comprising:

a battery information receiving step of receiving battery information for a plurality of batteries;
an index value determining step of determining an index value for a plurality of performance indexes for the plurality of batteries, based on the battery information;
an index value comparing step of comparing the plurality of index values determined for the plurality of batteries; and
a pairing step of pairing corresponding batteries among the plurality of batteries according to the comparison result.

FIG. 1

BATTERY PAIRING APPARATUS ~100

| BATTERY PAIRING APPARATUS |
|---|
| COMMUNICATION UNIT ~110 |
| INDEX VALUE DETERMINING UNIT ~120 |
| BATTERY DETERMINING UNIT ~130 |
| STORAGE UNIT ~140 |

FIG. 2

| PERFORMANCE INDEX | PRIORITY |
|---|---|
| SOC | 1 |
| SOH | 2 |
| UNIT CHARGE CAPACITY | 3 |
| DETERIORATION RATE | 4 |

FIG. 3

**BATTERY INFORMATION TABLE(BT)**

| BATTERY ID | PAIR ID | BATTERY INFORMATION |
|---|---|---|
| B1 | P1 | |
| B2 | P1 | |
| B3 | P2 | |
| B3 | P2 | |

FIG. 4

**PAIRING INFORMATION TABLE(PT)**

| PAIR ID | PAIRING INFORMATION |
|---------|---------------------|
| P1      |                     |
| P2      |                     |

FIG. 5

B1  B2  B3  B4

B5  B6  B7  B8

B9  B10  B11  B12

FIG. 6

A

B1    B2        B3    B4

B5    B6        B7    B8    B

B9    B10       B11   B12

FIG. 7

C

B1    B2        B3    B4

B5    B6        B7    B8    E

D   B9    B10      B11   B12   F

FIG. 8

FIG. 9

FIG. 10

FIG. 11

## INTERNATIONAL SEARCH REPORT

| International application No. |
| --- |
| **PCT/KR2023/013276** |

### A. CLASSIFICATION OF SUBJECT MATTER

**B60L 53/126**(2019.01)i; **B60L 53/80**(2019.01)i; **B60L 53/53**(2019.01)i; **G06Q 50/30**(2012.01)i

According to International Patent Classification (IPC) or to both national classification and IPC

### B. FIELDS SEARCHED

Minimum documentation searched (classification system followed by classification symbols)

B60L 53/126(2019.01); B60L 11/18(2006.01); B60L 53/60(2019.01); B60L 53/80(2019.01); B60L 58/16(2019.01); G01R 31/36(2006.01); G01R 31/367(2019.01); G01R 31/382(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 페어링(pairing), 성능(performance), 비교(comparison), 우선순위 (priority)

### C. DOCUMENTS CONSIDERED TO BE RELEVANT

| Category* | Citation of document, with indication, where appropriate, of the relevant passages | Relevant to claim No. |
| --- | --- | --- |
| X | KR 10-2285079 B1 (GOGORO INC.) 11 August 2021 (2021-08-11)<br>See paragraphs [0014]-[0016] and [0038]; claims 1 and 13; and figure 1. | 1,6,10-12 |
| Y | | 2-3,7-9 |
| A | | 4-5 |
| Y | KR 10-2022-0120870 A (PMGROW CORPORATION) 31 August 2022 (2022-08-31)<br>See claims 1 and 5. | 2-3 |
| Y | KR 10-0911317 B1 (LG CHEM, LTD.) 11 August 2009 (2009-08-11)<br>See claim 14. | 7-9 |
| A | KR 10-2021-0119329 A (LG ENERGY SOLUTION, LTD.) 05 October 2021 (2021-10-05)<br>See claim 1; and figure 1. | 1-12 |

☑ Further documents are listed in the continuation of Box C.      ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **04 December 2023** | **04 December 2023** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/013276** |

**C.      DOCUMENTS CONSIDERED TO BE RELEVANT**

| Category* | Citation of document, with indication, where appropriate, of the relevant passages | Relevant to claim No. |
| --- | --- | --- |
| A | US 9079505 B1 (ELWHA LLC.) 14 July 2015 (2015-07-14)<br>       See claim 1; and figure 23. | 1-12 |

Form PCT/ISA/210 (second sheet) (July 2022)

### INTERNATIONAL SEARCH REPORT
#### Information on patent family members

International application No.

**PCT/KR2023/013276**

| Patent document cited in search report | | | Publication date (day/month/year) | Patent family member(s) | | | Publication date (day/month/year) |
|---|---|---|---|---|---|---|---|
| KR | 10-2285079 | B1 | 11 August 2021 | CN | 109993342 | A | 09 July 2019 |
| | | | | CN | 110010988 | A | 12 July 2019 |
| | | | | EP | 3506455 | A1 | 03 July 2019 |
| | | | | EP | 3506456 | A1 | 03 July 2019 |
| | | | | JP | 2019-146474 | A | 29 August 2019 |
| | | | | JP | 2019-154220 | A | 12 September 2019 |
| | | | | JP | 6815379 | B2 | 20 January 2021 |
| | | | | JP | 6823641 | B2 | 03 February 2021 |
| | | | | KR | 10-2019-0082146 | A | 09 July 2019 |
| | | | | KR | 10-2019-0088402 | A | 26 July 2019 |
| | | | | KR | 10-2238078 | B1 | 09 April 2021 |
| | | | | PH | 12019000007 | A1 | 24 July 2019 |
| | | | | PH | 12019000008 | A1 | 24 July 2019 |
| | | | | TW | 201931282 | A | 01 August 2019 |
| | | | | TW | 201937442 | A | 16 September 2019 |
| | | | | TW | I740082 | B | 21 September 2021 |
| | | | | TW | I774900 | B | 21 August 2022 |
| | | | | US | 10992155 | B2 | 27 April 2021 |
| | | | | US | 11101677 | B2 | 24 August 2021 |
| | | | | US | 2019-0207393 | A1 | 04 July 2019 |
| | | | | US | 2019-0207398 | A1 | 04 July 2019 |
| KR | 10-2022-0120870 | A | 31 August 2022 | KR | 10-2569876 | B1 | 23 August 2023 |
| | | | | WO | 2022-181863 | A1 | 01 September 2022 |
| KR | 10-0911317 | B1 | 11 August 2009 | None | | | |
| KR | 10-2021-0119329 | A | 05 October 2021 | CN | 114450706 | A | 06 May 2022 |
| | | | | EP | 4064174 | A1 | 28 September 2022 |
| | | | | EP | 4064174 | A4 | 11 January 2023 |
| | | | | JP | 2022-547002 | A | 10 November 2022 |
| | | | | JP | 2023-103268 | A | 26 July 2023 |
| | | | | JP | 7269437 | B2 | 08 May 2023 |
| | | | | US | 2022-0281345 | A1 | 08 September 2022 |
| | | | | WO | 2021-194267 | A1 | 30 September 2021 |
| US | 9079505 | B1 | 14 July 2015 | None | | | |

**REFERENCES CITED IN THE DESCRIPTION**

**Patent documents cited in the description**

- KR 1020220111915
- KR 1020230117288